# EUROPEAN PATENT APPLICATION

(11) **EP 3 007 222 A2**
(43) Date of publication of application: **13.04.2016**
(21) Application number: 15187065.6
(22) Date of filing: 28.09.2015
(51) Int. Cl.: H01L 23/49, H01L 23/495, H01L 21/48, H02M 1/08

(54) **ROBUST AND RELIABLE POWER SEMICONDUCTOR PACKAGE**

(30) Priority: 09.10.2014 US 201462061837 P; 22.09.2015 US 201514861186
(71) Applicant: International Rectifier Corporation, El Segundo, CA 90245 (US)
(72) Inventor: Cho, Eung San, Torrance, CA 90505 (US)
(74) Representative: Dr. Weitzel & Partner

(57) **Abstract**

In one implementation, a semiconductor package includes a patterned conductive carrier including a support segment (330a) having a partially etched recess (344,364). The semiconductor package also includes an integrated circuit (IC)(350) situated on the support segment (330a), and an electrical connector (360) coupling the IC (350) to the partially etched recess (344,364). In addition, the semiconductor package includes a packaging dielectric (370) formed over the patterned conductive carrier (330a) and the IC (350). The packaging dielectric interfaces (370) with and mechanically engages the partially etched recess (344,364) so as to prevent delamination of the electrical connector (360).

## Description

### BACKGROUND

The present application claims the benefit of and priority to a provisional application entitled "Power Semiconductor Package with Enhanced Adhesion and MSL," Serial No. 62/061,837 filed on October 9, 2014. The disclosure in this provisional application is hereby incorporated fully by reference into the present application.

### BACKGROUND ART

Power converters, such as voltage regulators, are used in a variety of electronic circuits and systems. For example, a buck converter may be implemented to convert a higher voltage direct current (DC) input to a lower voltage DC output for use in low voltage applications in which relatively large output currents are required.

The output stage of a power converter may include power transistors implemented as respective control and synchronous (sync) transistors, as well as a driver IC designed to drive one or both of the control and sync transistors. The driver IC may be packaged individually or may be co-packaged with the power transistors as part of the output stage. However, due to typically poor adhesion between a molding compound used to encapsulate such packages, and the conductive carrier providing structural support for the package components, electrical connectors used to couple those components to the surface of the conductive carrier are undesirably susceptible to delamination.

### SUMMARY

The present disclosure is directed to a robust and reliable power semiconductor package, substantially as shown in and/or described in connection with at least one of the figures, and as set forth in the claims.

### BRIEF DESCRIPTION OF THE DRAWINGS

Figure 1 shows a diagram of an exemplary power converter.
Figure 2 shows a flowchart presenting an exemplary method for fabricating a semiconductor package having a mechanically engaged packaging dielectric, according to one implementation.
Figures 3A illustrates a result of performing an initial action according to the exemplary flowchart of Figure 2 in accordance with one implementation.
Figures 3B illustrates a result of performing a subsequent action according to the exemplary flowchart of Figure 2 in accordance with one implementation.
Figures 3C illustrates a result of performing a subsequent action according to the exemplary flowchart of Figure 2 in accordance with one implementation.
Figures 3D illustrates a result of performing a subsequent action according to the exemplary flowchart of Figure 2 in accordance with one implementation.
Figures 3E illustrates a result of performing a final action according to the exemplary flowchart of Figure 2 in accordance with one implementation.
Figures 3F illustrates a result of performing a final action according to the exemplary flowchart of Figure 2 in accordance with another implementation.
Figure 4 provides a top view of an exemplary semiconductor package having a mechanically engaged packaging dielectric, as though seen through the packaging dielectric, according to yet another implementation.
Figure 5 shows a cross-sectional view of the exemplary semiconductor package shown in Figure 4, according to one implementation.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

As stated above, power converters, such as voltage regulators, are used in a variety of electronic circuits and systems. For instance, and as also stated above, a buck converter may be implemented as a voltage regulator to convert a higher voltage direct current (DC) input to a lower voltage DC output for use in low voltage applications in which relatively large output currents are required.

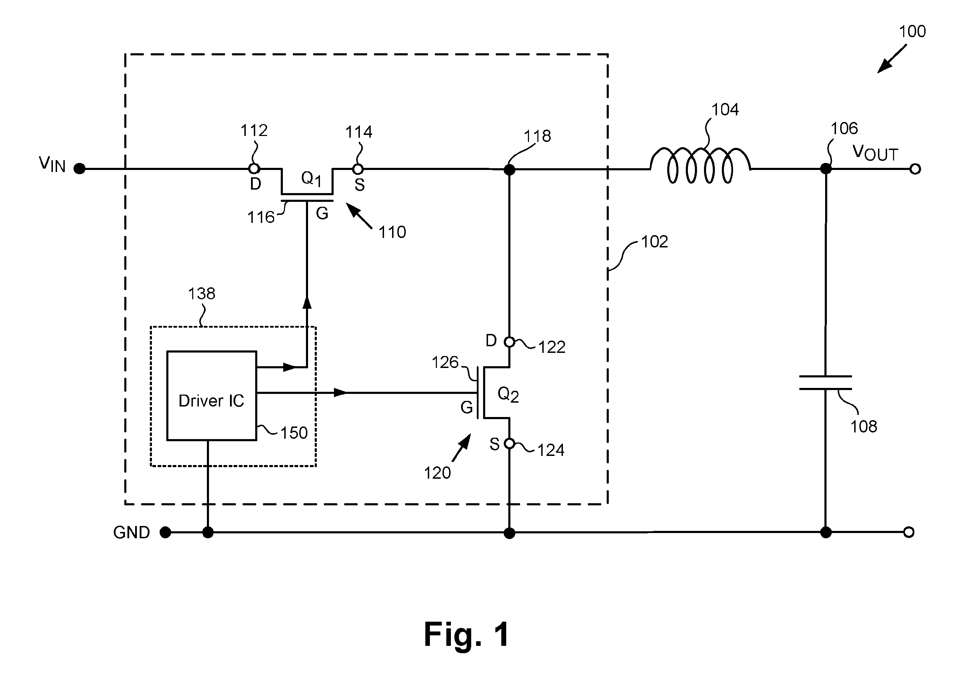

Figure 1 shows a diagram of an exemplary power converter. Power converter 100 includes output stage 102, output inductor 104, and output capacitor 108. As shown in Figure 1, power converter 100 is configured to receive an input voltage V_{IN}, and to provide a converted voltage, e.g., a rectified and/or stepped down voltage, as V_{OUT} at output 106.

Output stage 102 may be implemented using two power switches in the form of metal-oxide-semiconductor field-effect transistors (MOSFETs) configured as a half bridge, for example. That is to say, output stage 102 may include high side or control FET 110 (Q₁) having drain 112, source 114, and gate 116, as well as low side or synchronous (sync) FET 120 (Q₂) having drain 122, source 124, and gate 126. In addition, output stage 102 may include driver integrated circuit (IC) 150 providing drive signals to one or both of control FET 110 and sync FET 120. However, it is noted that in some implementations, it may be advantageous or desirable to package driver IC 150 individually, as shown in Figure 1 by discrete driver IC package 138.

As further shown in Figure 1, control FET 110 is coupled to sync FET 120 at switch node 118, which, in turn, is coupled to output 106 through output inductor 104. Respective control and sync FETs 110 and 120 may be implemented as group IV based power FETs, such as silicon power MOSFETs having a vertical design, for example. Power converter 100 may be advantageously utilized, for example as a buck converter, in a variety of automotive, industrial, appliance, and lighting applications.

It is noted that in the interests of ease and conciseness of description, the present inventive principles will in some instances be described by reference to specific implementations of a buck converter including one or more silicon based power FETs. However, it is emphasized that such implementations are merely exemplary, and the inventive principles disclosed herein are broadly applicable to a wide range of applications, including buck and boost converters, implemented using other group IV material based, or group III-V semiconductor based, power transistors.

It is further noted that as used herein, the phrase "group III-V" refers to a compound semiconductor including at least one group III element and at least one group V element. By way of example, a group III-V semiconductor may take the form of a III-Nitride semiconductor that includes nitrogen and at least one group III element. For instance, a III-Nitride power FET may be fabricated using gallium nitride (GaN), in which the group III element or elements include some or a substantial amount of gallium, but may also include other group III elements in addition to gallium. Thus, in some implementations, one or both of control FET 110 and sync FET 120 may take the form of a III-Nitride power FET, such as a III-Nitride high electron mobility transistor (HEMT).

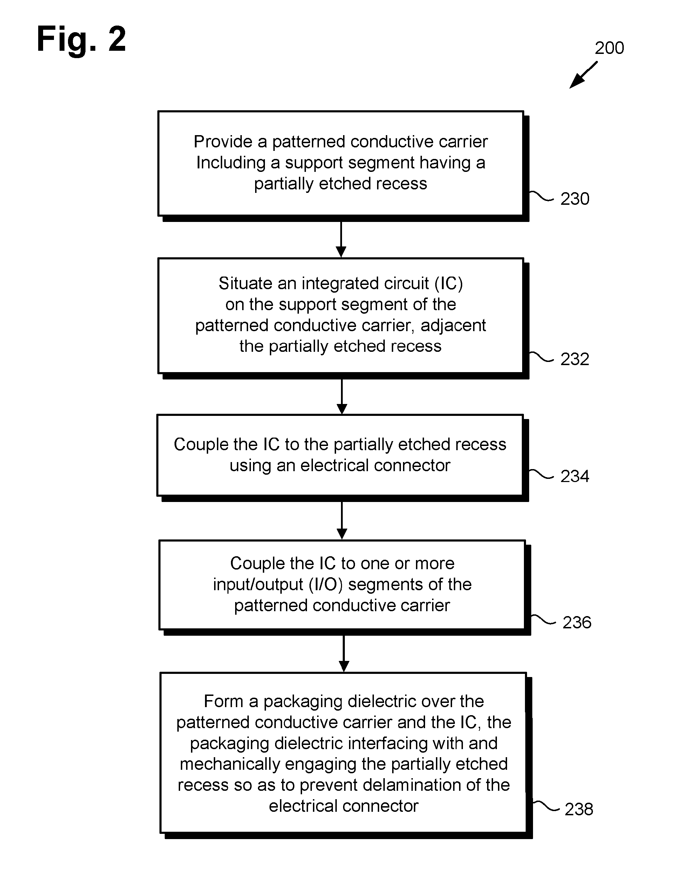

Continuing to Figure 2, Figure 2 shows flowchart 200 presenting an exemplary method for fabricating a semiconductor package having a mechanically engaged packaging dielectric. The exemplary method described by flowchart 200 is performed on a portion of a conductive carrier structure, which may be a semiconductor package lead frame, or may take the form of a conductive sheet or plate, for example.

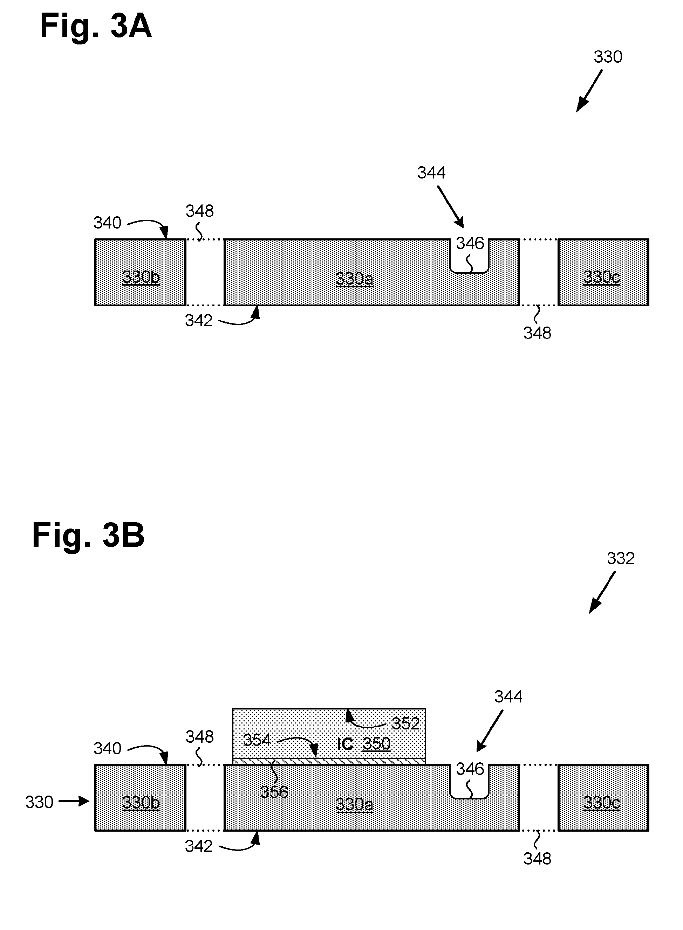

With respect to Figures 3A-3E, structures 330, 332, 334, 336, and 338E shown respectively in those figures illustrate the result of performing the method of flowchart 200, according to one implementation. For example, Figure 3A represents providing patterned conductive carrier 330 including support segment 330a having a partially etched recess, as well as input/output (I/O) segments 330b and 330c (action 230). Structure 332 shows patterned conductive carrier 330 having an IC situated on support segment 330a (action 232). Structure 334 shows structure 332 after attachment of an electrical connector coupling the IC to the partially etched recess (action 234), and so forth.

Referring to flowchart 200, in Figure 2, in combination with Figure 3A, flowchart 200 begins with providing patterned conductive carrier 330 having die receiving side 340, and opposite surface mounting side 342 (action 230). As shown in Figure 3A, patterned conductive carrier 330 may be a fully patterned conductive carrier including support segment 330a and I/O segments 330b and 330c. As further shown in Figure 3A, support segment 330a includes partially etched recess 344 having bottom surface 346.

It is noted that support segment 330a and I/O segments 330b and 330c are shown as connected by dashed lines 348 to indicate that the gaps between those respective segments may be visible in Figures 3A-3D due to patterning of an initially contiguous conductive carrier structure providing patterned conductive carrier 330. That is to say, patterned conductive carrier 330 may be provided by a single conductive carrier support structure, fully patterned to provide support segment 330a and I/O segments 330b and 330c. Patterned conductive carrier 330 may be formed of any conductive material having a suitably low electrical resistance. Examples of materials from which patterned conductive carrier 330 may be formed include copper (Cu), aluminum (Al), or a conductive alloy. In one implementation, as noted above, patterned conductive carrier 330 may be implemented using at least a portion of a semiconductor package lead frame.

Partially etched recess 344 on die receiving side 340 of support segment 330a may be produced by a partial etch performed on a portion of support segment 330a, resulting in partially etched recess 344 being formed as a partially etched trench on die receiving side 340 of support segment 330a. In one implementation, for example, partially etched recess 344 may be produced by performing a half-etch of a portion of support segment 330a, on die receiving side 340, to form a substantially half-etched trench corresponding to partially etched recess 344. It is noted that portions of support segment 330a other than partially etched recess 344, as well as I/O segments 330b and 330c may be substantially non-etched.

Although not shown in the present figures, in some implementations, patterned conductive carrier 332 may include a barrier metal layer formed on one or both of die receiving side 340 and surface mounting side 342. Such a barrier metal layer may be formed of nickel-gold (NiAu) or nickel-palladium-gold (NiPdAu), for example. In some implementations, such a barrier metal layer may serve as an etching mask during patterning of patterned conductive carrier 330.

Moving to structure 332 in Figure 3B with ongoing reference to Figure 2, flowchart 200 continues with situating IC 350 on patterned conductive carrier 330 (action 232). As shown in Figure 3B, IC 350 is situated on die receiving side 340 of support segment 330a, adjacent partially etched recess 344. As further shown in Figure 3B, IC 350 has bottom surface 354 attached to die receiving side 340 of support segment 330a by die attach material 356, which may be an electrically conductive die attach material or a dielectric die attach material. Also shown in Figure 3B is top surface 352 of IC 350, opposite bottom surface 354. IC 350 corresponds in general to driver IC 150, in Figure 1, and may share any of the characteristics attributed to that corresponding feature in the present application.

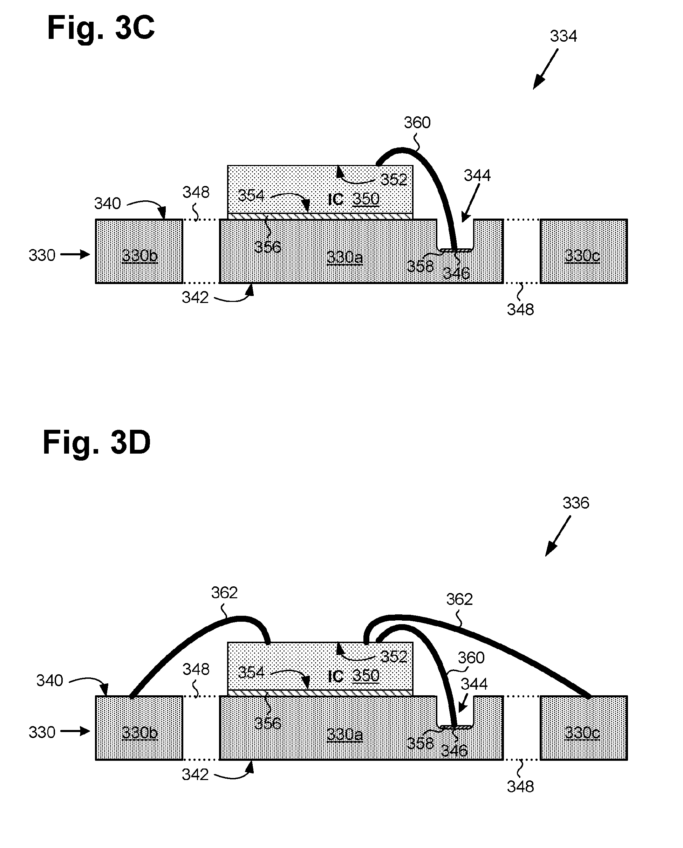

Referring to structure 334 in Figure 3C, flowchart 200 continues with coupling IC 350 to partially etched recess 344 using electrical connector 360 (action 234). As shown in Figure 3C, in some implementations, electrical connector 360 may be coupled between top surface 352 of IC 350 and bottom surface 346 of partially etched recess 344. Moreover, in some implementations, and as further shown in Figure 3C, conductive plating 358 may be formed in partially etched recess 344 to facilitate contact between electrical connector 360 and partially etched recess 344. In some implementations, support segment 330a may be configured to provide a ground contact for IC 350. In those implementations, IC 350 may be electrically grounded via support segment 330a, conductive plating 358 when present, and electrical connector 360.

When present, conductive plating 358 may formed of silver (Ag), for example, or any other conductive metal or metal alloy suitable for enhancing contact between electrical connector 360 and partially etched recess 344. It is noted that although electrical connector 360 is depicted as wire bond in Figure 3C, such as gold (Au), Cu, or Al wire bond, for example, that representation is merely for the purposes of conceptual clarity. More generally, electrical connector 360 may be implemented using conductive clips, ribbons, or strips, for example.

Moving to structure 336 in Figure 3D, flowchart 200 continues with coupling IC 350 to I/O segments 330b and 330c of patterned conductive carrier 330 (action 236). As shown in Figure 3D, in some implementations, I/O connectors 362 may be coupled between top surface 352 of IC 350 and die receiving side 340 of I/O segments 330b and 330c. Analogously to electrical connector 360, I/O connectors 362, although depicted as wire bonds in Figure 3D, can more generally be implemented using conductive clips, ribbons, or strips.

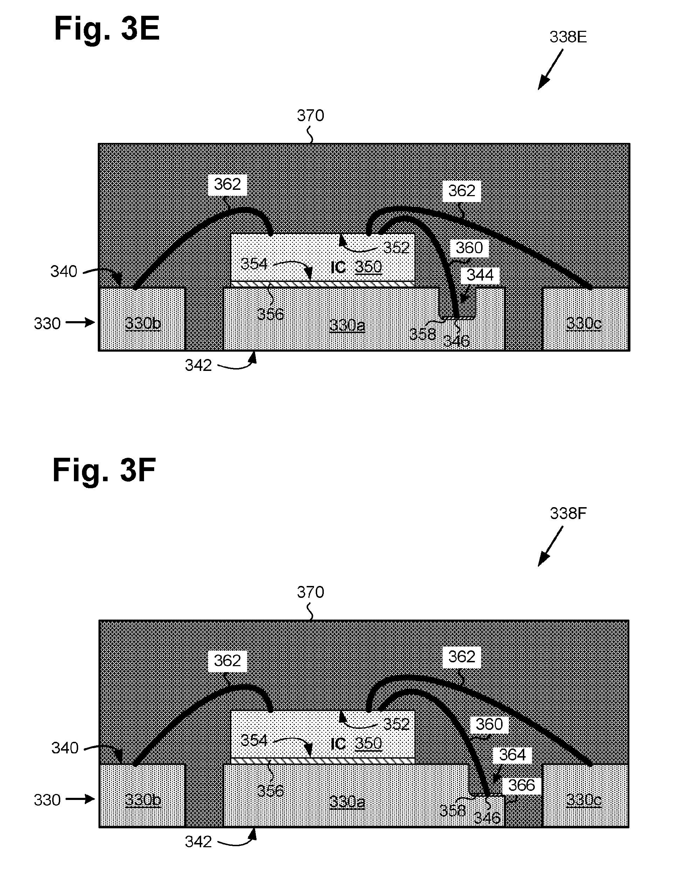

Continuing to structure 338E in Figure 3E, flowchart 200 may conclude with forming packaging dielectric 370 over patterned conductive carrier 330 and IC 350 (action 238). As shown in Figure 3E, packaging dielectric 370 substantially fills partially etched recess 344 so as to interface with and mechanically engage partially etched recess 344. By interfacing with and mechanically engaging partially etched recess 344, packaging dielectric 370 advantageously prevents delamination of electrical connector 360. Packaging dielectric 370 may be any suitable electrically insulating material used as overmolding or encapsulation in semiconductor packaging.

Structure 338E provides a semiconductor package corresponding in general to discrete driver IC package 138, in Figure 1, and may share any of the characteristics attributed to that corresponding feature in the present application. Thus, structure 338E depicts one exemplary implementation of a semiconductor package having a mechanically engaged packaging dielectric, according to the inventive concepts disclosed herein.

Referring now to Figure 3F, semiconductor package 338F in Figure 3F presents another exemplary implementation of a semiconductor package having a mechanically engaged packaging dielectric. It is noted that all features in Figure 3F identified by reference numbers shown in and described by reference to Figure 3A through Figure 3E, above, correspond respectively to those features and may share any of the characteristics attributed to those corresponding features in the present application.

In contrast to the exemplary packaging solution shown in Figure 3E, however, in which partially etched recess 344 is implemented as a trench formed in support segment 330a, partially etched recess 364 of semiconductor package 338F is implemented as a ledge. For example, and as shown in Figure 3F, partially etched recess 364 may be formed as a partially etched ledge, such as a substantially half-etched ledge, at boundary 366 of support segment 330a. Analogously to the packaging solution shown in Figure 3E, in semiconductor package 338F, packaging dielectric 370 interfaces with and mechanically engages partially etched recess 364 so as to advantageously prevent delamination of electrical connector 360.

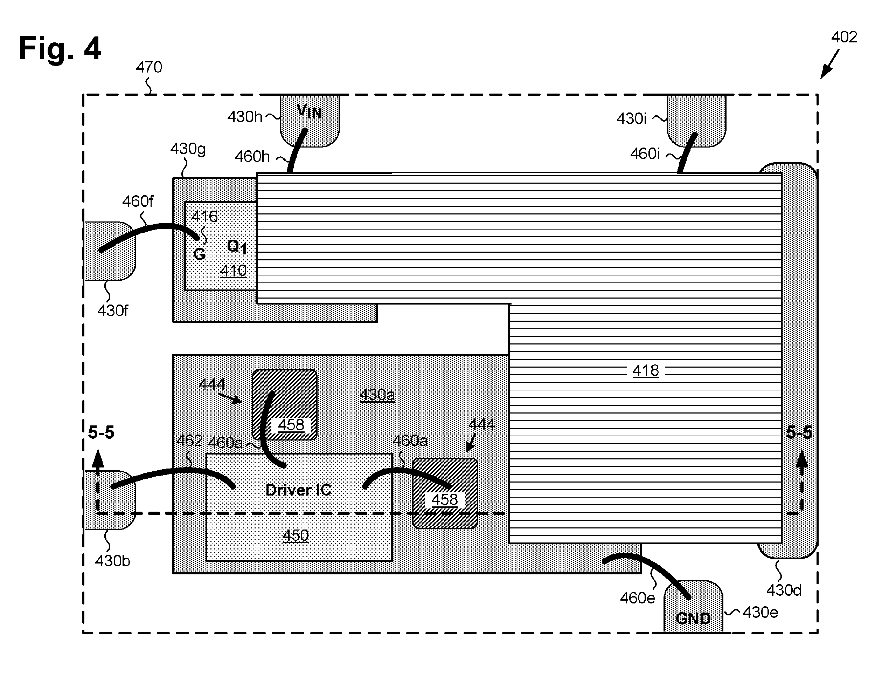

Moving to Figure 4, Figure 4 provides a top view of exemplary semiconductor package 402 having mechanically engaged packaging dielectric 470, as though seen through packaging dielectric 470, according to yet another implementation. Semiconductor package 402 includes a patterned conductive carrier providing support segment 430a, I/O segment 430b, a sync gate segment (not visible from the perspective shown in Figure 4), switch node segment 430d, ground segment 430e, control gate segment 430f, control drain segment 430g, input segment 430h, and segment 430i coupled to the sync gate segment by electrical connector 460i.

As shown in Figure 4, support segment 430a includes partially etched recesses 444, which may be substantially half-etched, for example, and according to the present exemplary implementation include optional conductive plating 458 formed on the respective bottom surfaces of partially etched recesses 444. It is noted that portions of support segment 430a other than partially etched recesses 444, as well as I/O segment 430b, the sync gate segment, switch node segment 430d, ground segment 430e, control gate segment 430f, control drain segment 430g, input segment 430h, and segment 430i may be substantially non-etched.

Semiconductor package 402 includes control FET 410 (Q₁) having a control drain coupled to control drain segment 430g and a control source coupled to conductive clip 418 (control drain and control source not visible from the perspective shown in Figure 4). In addition, control FET 410 includes control gate 416 coupled to control gate segment 430f of the patterned conductive carrier by electrical connector 460f. Semiconductor package 402 also includes a sync FET (Q₂) having a sync drain coupled to conductive clip 418, a sync source coupled to support segment 430a, and a sync gate (the sync FET Q₂ also not visible from the perspective shown by Figure 4 due to being overlaid by conductive clip 418).

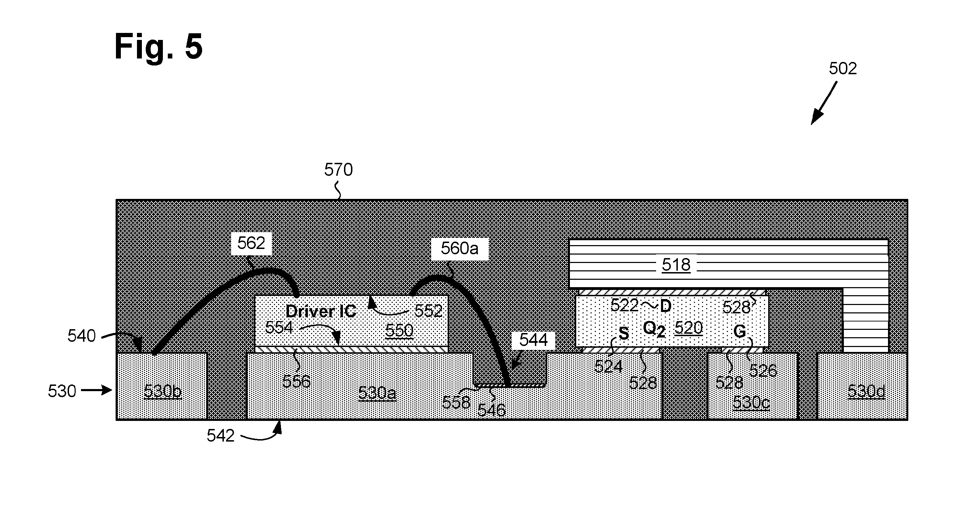

Semiconductor package 402 also includes driver IC 450 for driving at least one of control FET 410 and the sync FET Q₂. Also shown in Figure 4 are electrical connectors 460a coupling driver IC 450 to partially etched recesses 444, I/O connector 462 coupling driver IC 450 to I/O segment 430b, electrical connector 460e coupling support segment 430a to ground segment 430e, and electrical connector 460h coupling control drain segment 430g to input segment 430h. Figure 4 further shows perspective lines 5-5 corresponding to the cross-sectional view of semiconductor package 402 shown by Figure 5 and discussed below.

Semiconductor package 402 corresponds in general to output stage 102, in Figure 1, and may share any of the characteristics attributed to that corresponding feature, above. Packaging dielectric 470, which is represented as being effectively transparent in Figure 4, corresponds in general to packaging dielectric 370 in Figures 3E and 3F, and may share any of the characteristics attributed to that corresponding feature in the present application. In addition, control FET 410 and the sync FET Q₂ included in semiconductor package 402 correspond respectively in general to control FET 110 and sync FET 120, in Figure 1, and may share any of the characteristics attribute to those corresponding features in the present application. In other words, control FET 410 and the sync FET Q₂ may be implemented as silicon power FETs, or as group III-V power FETs such as III-Nitride FETs or HEMTs, for example.

It is noted that conductive clip 418 couples the control source of control FET 410 to the sync drain of the sync FET Q₂ included in semiconductor package 402, and thus corresponds in general to switch node 118, in Figure 1. Driver IC 450, in Figure 4, corresponds in general to driver IC 150 in Figure 1, as well as to IC 350 in Figure 3B through Figure 3F, and may share any of the characteristics attribute to those corresponding features in the present application.

Support segment 430a including partially etched recesses 444, in Figure 4, corresponds in general to support segment 330a including partially etched recess 344/364, in Figure 3A through Figure 3F, and may share any of the characteristics attribute to those corresponding features in the present application. Furthermore, conductive plating 458, I/O segment 430b, I/O connector 462, and electrical connectors 460a, 460e, 460f, 460h, and 460i, in Figure 4, correspond respectively in general to conductive plating 358, I/O segment 330b, I/O connector 362, and electrical connector 360, shown in Figures 3C through 3F. That is to say, although I/O connector 462 and electrical connectors 460a, 460e, 460f, 460h, and 460i are represented as wire bond for simplicity in Figure 4, any or all of those connectors may be implemented using conductive clips, ribbons, or strips.

Continuing to Figure 5, Figure 5 shows a cross-sectional view of the exemplary semiconductor package of Figure 4, along perspective lines 5-5 in that figure, according to one implementation. Semiconductor package 502 includes patterned conductive carrier 530 having die receiving side 540, and opposite surface mounting side 542. As shown in Figure 5, patterned conductive carrier 530 may be a fully patterned conductive carrier including support segment 530a, I/O segment 530b, sync gate segment 530c, and switch node segment 530d. As further shown in Figure 5, support segment 530a includes partially etched recess 544 having optional conductive plating 558 formed at bottom surface 546.

Patterned conductive carrier 530 may be formed of any conductive material having a suitably low electrical resistance. Examples of materials from which patterned conductive carrier 530 may be formed include copper Cu, aluminum Al, or a conductive alloy. In one implementation, patterned conductive carrier 530 may be implemented using at least a portion of a semiconductor package lead frame.

Partially etched recess 544 on die receiving side 540 of support segment 530a may be produced by a partial etch performed on a portion of support segment 530a, resulting in partially etched recess 544 being formed as a partially etched trench or ledge on die receiving side 540 of support segment 530a. In one implementation, for example, partially etched recess 544 may be produced by performing a half-etch of a portion of support segment 530a, on die receiving side 540, to form a substantially half-etched trench or ledge corresponding to partially etched recess 544. It is noted that portions of support segment 530a other than partially etched recess 544, as well as I/O segment 530b, sync gate segment 530c, and switch node segment 530d may be substantially non-etched.

As shown in Figure 5, semiconductor package 502 includes driver IC 550 having bottom surface 554 attached to die receiving side 540 of support segment 530a by die attach material 556 so as to be situated on support segment 530a, adjacent partially etched recess 544. As further shown in Figure 5, electrical connector 560a couples top surface 552 of driver IC 550 to partially etched recess 544, while I/O connector 562 couples top surface 552 of driver IC 550 to die receiving side 540 of I/O segment 530b.

Semiconductor package 502 also includes sync FET 520 (Q₂) having sync source 524 coupled to die receiving side 540 of support segment 530a by electrically conductive die attach material 528, and having sync gate 526 coupled to die receiving side 540 of sync gate segment 530c by electrically conductive die attach material 528. Moreover, sync FET 520 includes sync drain 522 coupled to switch node segment 530d of conductive carrier 530 by conductive clip 518 and electrically conductive die attach material 528. Also shown in Figure 5 is packaging dielectric 570 formed over patterned conductive carrier 530, driver IC 550, and sync FET 520.

As noted above by reference to Figure 4, semiconductor package 502 corresponds in general to output stage 102, in Figure 1, and may share any of the characteristics attributed to that corresponding feature, above. Packaging dielectric 570 corresponds in general to packaging dielectric 470 in Figure 4, and may share any of the characteristics attributed to that corresponding feature, above. In addition, die attach material 556 corresponds in general to die attach material 356, in Figure 3B through Figure 3F, and may share any of the characteristics attributed to that corresponding feature, above. Patterned conductive carrier 530, in Figure 5, corresponds in general to the patterned conductive carrier providing support segment 430a, I/O segment 430b, the sync gate segment (not visible from the perspective shown in Figure 4), switch node segment 430d, ground segment 430e, control gate segment 430f, control drain segment 430g, input segment 430h, and segment 430i, in Figure 4.

Sync FET 520, in Figure 5, corresponds in general to sync FET 120, in Figure 1, and may share any of the characteristics attribute to that corresponding feature in the present application. In other words, sync FET 520 may be implemented as a silicon power FET, or as a group III-V power FET such as a III-Nitride FET or HEMT, for example. Moreover, conductive clip 518, in Figure 5, corresponds in general to conductive clip 418, in Figure 4, which couples the control source of control FET 410 to sync drain 522 of sync FET 520. Furthermore, driver IC 550, in Figure 5, corresponds in general to driver IC 450, in Figure 4, and may share any of the characteristics attribute to that corresponding feature, above.

Support segment 530a including partially etched recess 544, I/O segment 530b, and switch node segment 530d, in Figure 5, correspond respectively in general to support segment 430a including partially etched recesses 444, I/O segment 430b, and switch node segment 430d, in Figure 4, and may share any of the characteristics attribute to those corresponding features, above. Furthermore, conductive plating 558, I/O connector 562, and electrical connector 560a, in Figure 5, correspond respectively in general to conductive plating 458, I/O connector 462, and electrical connector 460a, in Figure 4 and may share any of the characteristics attribute to those corresponding features, above.

According to the exemplary implementation shown in Figures 4 and 5, support segment 430a/530a of patterned conductive carrier 530 is configured to provide a ground contact for driver IC 550 and sync FET 520. For example, as shown in Figure 5, driver IC 550 is coupled to partially etched recess 544 of support segment 530a by electrical connector 560a, while sync source 524 of sync FET 520 is coupled to support segment 530a by electrically conductive die attach material 528. Moreover, and as further shown by Figure 4, support segment 430a is coupled to ground segment 430e by electrical connector 460e.

As shown in Figure 5, packaging dielectric 570 substantially fills partially etched recess 544 so as to interface with and mechanically engage partially etched recess 544. By interfacing with and mechanically engaging partially etched recess 544, packaging dielectric 570 advantageously prevents delamination of electrical connector 560a. Thus, semiconductor package 502 depicts another exemplary implementation of a semiconductor package having a mechanically engaged packaging dielectric, according to the inventive concepts disclosed herein.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A semiconductor package comprising:
a patterned conductive carrier including a support segment having a partially etched recess;
an integrated circuit (IC) situated on said support segment;
an electrical connector coupling said IC to said partially etched recess;
a packaging dielectric formed over said patterned conductive carrier and said IC, said packaging dielectric interfacing with and mechanically engaging said partially etched recess so as to prevent delamination of said electrical connector.

2. The semiconductor package of claim 1, wherein said partially etched recess comprises a trench formed in said support segment.

3. The semiconductor package of claim 1, wherein said partially etched recess comprises a ledge formed at a boundary of said support segment.

4. The semiconductor package of claim 1, wherein said partially etched recess is substantially half-etched.

5. The semiconductor package of claim 1, wherein said support segment is configured to provide a ground contact for said IC.

6. The semiconductor package of claim 1, wherein said patterned conductive carrier comprises at least a portion of a lead frame.

7. The semiconductor package of claim 1, further comprising a control FET having a control drain coupled to a control drain segment of said patterned conductive carrier, and a sync FET having a sync source coupled to said support segment.

8. The semiconductor package of claim 7, wherein said support segment is configured to provide a ground contact for said IC and said sync FET.

9. The semiconductor package of claim 7, wherein said control FET and said sync FET comprise silicon power FETs.

10. The semiconductor package of claim 7, wherein said control FET and said sync FET comprise III-Nitride FETs.

11. A method for fabricating a semiconductor package, said method comprising:
providing a patterned conductive carrier including a support segment having a partially etched recess;
situating an integrated circuit (IC) on said support segment;
coupling said IC to said partially etched recess by an electrical connector;
forming a packaging dielectric over said patterned conductive carrier and said IC, said packaging dielectric interfacing with and mechanically engaging said partially etched recess so as to prevent delamination of said electrical connector.

12. The method of claim 11, wherein said partially etched recess comprises a trench formed in said support segment.

13. The method of claim 11, wherein said partially etched recess comprises a ledge formed at a boundary of said support segment.

14. The method of claim 11, wherein said partially etched recess is substantially half-etched.

15. The method of claim 11, wherein said support segment is configured to provide a ground contact for said IC.
